# EUROPEAN PATENT SPECIFICATION

(11) **EP 0 617 852 B1**
(45) Date of publication and mention of the grant of the patent: **25.02.1998**
(21) Application number: 93902712.4
(22) Date of filing: 21.12.1992
(51) Int. Cl.: H01S 3/133, H04B 10/14

(54) **APPARATUS AND METHOD FOR CONTROLLING AN EXTINCTION RATIO OF A LASER DIODE OVER TEMPERATURE**
VORRICHTUNG UND VERFAHREN ZUR STEUERUNG DER TEMPERATURABHÄNGIGKEIT DES EIN/AUS-VERHÄLTNISSES EINER LASERDIODE
APPAREIL ET PROCEDE DE REGULATION DU RAPPORT D'EXTINCTION D'UNE DIODE LASER EN FONCTION DE LA TEMPERATURE

(30) Priority: 20.12.1991 US 811197
(43) Date of publication of application: 05.10.1994
(73) Proprietor: ERICSSON RAYNET, a Delaware general partnership, Menlo Park, CA 94025-1106 (US)
(72) Inventor: GELLER, William, L., Foster City, CA 94404 (US)
(74) Representative: Viering, Jentschura & Partner
(86) International application number: US9211157
(87) International publication number: WO9313577

(56) References cited:
- EP-A- 0 428 016
- US-A- 4 985 896
- US-A- 4 995 105
- US-A- 5 036 189
- PATENT ABSTRACTS OF JAPAN vol. 13, no. 109 (E-727)15 March 1989 & JP,A,63 280 482 ( NEC CORP )
- PATENT ABSTRACTS OF JAPAN vol. 8, no. 167 (E-258)2 August 1984 & JP,A,59 063 787 ( FUJITSU KK )
- PATENT ABSTRACTS OF JAPAN vol. 1, no. 213 (E-422)25 July 1986 & JP,A,61 052 042 ( HITACHI LTD )

## Description

The present invention relates to an apparatus for controlling an output of a laser diode over temperature so as to control and optimally maintain constant its extinction ratio, and a method for initially setting HIGH and LOW outputs of the laser diode so as to have a desired extinction ratio.

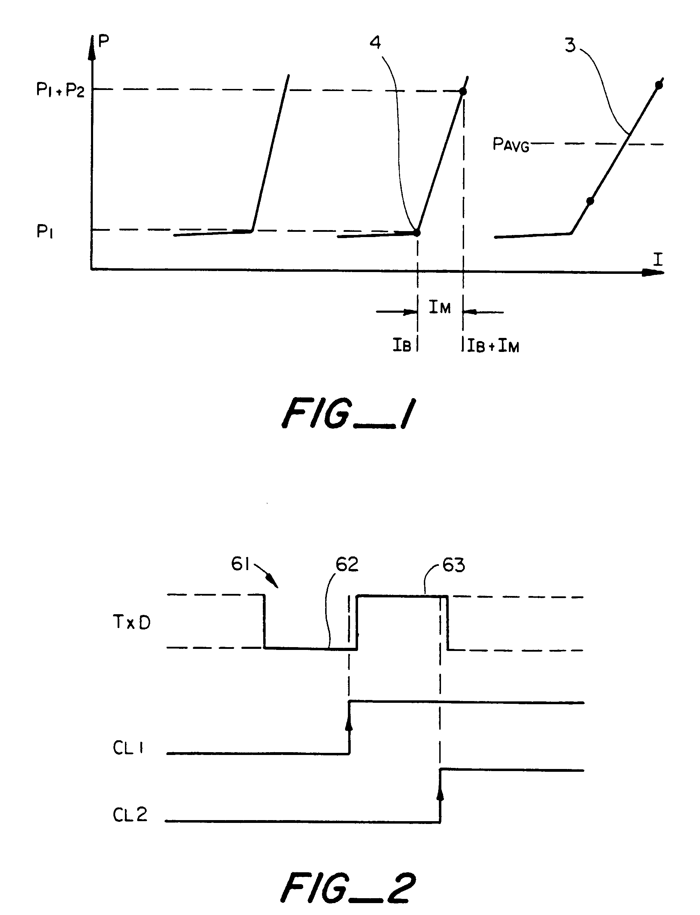

Various control circuits have been proposed in the prior art for maintaining an output of a laser diode. FIG 1 illustrates various characteristic curves for a laser diode whereby current I versus power P is graphed, the three curves illustrating data for a laser diode at three distinct temperatures. As is evident and known, a pedestal bias current 4 of the laser diode increases with temperature. One method of controlling an output of a laser diode is to incorporate a thermoelectric cooler into a laser package so as to keep the diode at a constant temperature so that its pedestal bias current remains constant. Accordingly, an extinction ratio of the laser diode, defined as the ratio between its HIGH power output divided by its LOW power output can easily be maintained constant. A disadvantage of such proposals is that thermoelectric cooler designs tend to increase the laser cost, and decreases reliability of the laser diode since any failure in the thermoelectric cooler device or its circuitry will result in the applied bias current being inappropriate as the temperature of the laser diode varies.

Circuits have also been proposed whereby a LOW pedestal power is monitored successively over time for the laser diode and incrementally increased or decreased in response to comparison to a preset dynamic threshold. One such circuit is described by Geller, USP 5,036,189, assigned to the assignee of the present invention. Though the Geller circuit readily establishes and maintains an appropriate LOW pedestal bias current, it does not control the HIGH power output of the laser. Referring back to FIG 1, since a slope of the current versus power output of a laser changes over temperature, for a constant modulation current I_{M,} the laser extinction ratio (the ratio between the laser HIGH power divided by the laser LOW power) will change over time. If the extinction ratio becomes too small, increased noise results at an optical receiver detecting an output of the laser which results in undesirable bit errors.

It has also been proposed to utilize circuitry which maintains the average laser modulation power constant over time. Such circuits also suffer from a disadvantage that the laser output extinction ratio will change with temperature. Specifically, referring to FIG 1, curve 3 illustrates how such circuitry works on an output of the laser and illustrates that noise detected by the receiver when the laser emits a LOW output is undesirably high, i.e. greater than the power output at the laser threshold pedestal.

EP-A-0 428 016 discloses a method and an apparatus for controlling the modulating current of a laser diode. This apparatus controls the modulating current in such a way that the slope ratio between the bias (logical 0) and the modulating (logical 1) operating points is fixed. Neither the actual laser output power levels nor the extinction ratio therebetween are controlled.

US-A-4,995,105 discloses a laser diode driver circuit for laser scanners which allows the continuous calibration of a laser so that the output power of the laser is accurately modulated by the input video signal regardless of temperature changes or aging effects of the laser. The circuit comprises two independent control loops for measuring the light output of the laser. By one of the control loops the low output is measured and compared to a reference, wherein the error therebetween is used to adjust the bias current of the laser. By the other control loop the difference between the low and high laser outputs is measured and compared to a second reference, wherein the error therebetween is used to adjust the gain of the video signal so that the difference between said low and high outputs is maintained constant.

US-A-4,985,896 discloses a laser driving device capable of providing a stable laser emission regardless of the ambient temperature by supplying the laser with a first current and a second bias current with controlled ratio between them. This driving device employs a single control loop by which only the high power output of laser is monitored and compared with a reference and the error is used to adjust said first current. The low power output of the laser corresponding to the second bias current is not separately monitored and adjusted only on the basis of the monitored high power output of the laser.

The object of the invention is to provide an apparatus and a method for controlling a laser light source, whereby both the low and the high output powers of the laser can be monitored independently from each other and adjusted over time to maintain the output of the laser at respective predetermined values, the extinction ratio of the laser output can be maintained constant over various temperatures and the low and high output powers of the laser can be simultaneously and easily adjusted without varying the laser extinction ratio.

This object is achieved according to the invention by an apparatus as defined in claim 1. The object relating to the method is achieved according to the invention by the method as claimed in claim 12. Preferred embodiments of the apparatus according to the invention are defined in claims 2 to 11.
FIG 1 illustrates several current versus power characteristic curves of a laser at various temperatures and shows bias and modulation current values;
FIG 2 illustrates a preferred frame preamble and clock times for use with the present invention;
FIG 3 illustrates a schematic of one embodiment of the invention for maintaining an extinction ratio of a laser constant;
FIG 4 illustrates a switch modulator shown in FIG 3; and
FIGs 5A and 5B together illustrate a preferred circuit implementation of the schematic illustrated in FIG 3;
FIG 6 illustrates a plurality of optical network units connected to a host digital terminal which includes a laser controlled according to the invention.

According to the invention, a circuit is provided for independently monitoring a pedestal bias output power P₁ (FIG 1) of a laser periodically over time, independently monitoring a HIGH power output P₁+P₂ of the laser over time, and independently increasing or decreasing these powers over time so that an extinction ratio of the laser is maintained constant and the laser LOW power is kept at its pedestal point.

As indicated, the extinction ratio N is defined as the HIGH laser output power P₁+P₂ divided by the LOW laser output power P₁. For N greater than 10, the extinction ratio is approximated by P₂/P₁.

Referring to FIG 2, a control circuit is proposed for use for information frames 61 which preferably include training pulses 62, 63, the training pulses comprising several successive binary LOWs followed by several successive binary HIGHs, preferably the successive LOWs and HIGHs each comprising a byte or more of bandwidth (typically 8 bits, or 10 bits for 4B5B coding of 8 bit bytes). According to a preferred embodiment, this LOW-HIGH training pulse is transmitted once per frame. At an appropriate instant near an end of the successive binary LOW period, the laser power output is strobed by clock CL1 and measured and compared to a preset dynamic LOW power reference value. If the measured LOW power is below the preset dynamic LOW power reference value, a bias current IB to the laser is incrementally increased. Similarly, any time the strobed and measured power is above the preset dynamic LOW power reference value, the pedestal bias current is incrementally decreased. It is readily evident that if this done repetitively, the bias current supplied to the laser can be readily adjusted so as to keep the bias current at the laser pedestal threshold regardless of the speed with which the pedestal may move as induced by laser aging or more commonly due to temperature variations. According to a preferred embodiment, as indicated, this measurement and comparison is done once per frame, and at a frame rate of 8 KHz, 8,000 bias current adjustments per second are achievable. Accordingly, the bias current will toggle about the LOW power reference value.

In addition, similarly at an appropriate instant near an end of the successive binary HIGH training pulse period, the laser power is again strobed by clock CL2, measured, and compared to another preset dynamic HIGH power reference value and when the strobed and measured power is below the preset HIGH reference value a modulation current I_{M} to the laser is increased and whenever it is above the preset HIGH reference value the modulation current I_{M} is decreased. Accordingly, the modulation current will also toggle about a desired level. Hence both the HIGH power output and LOW power output are independently measured and compared repetitively over time keeping these values relatively constant so as to maintain the laser extinction ratio constant.

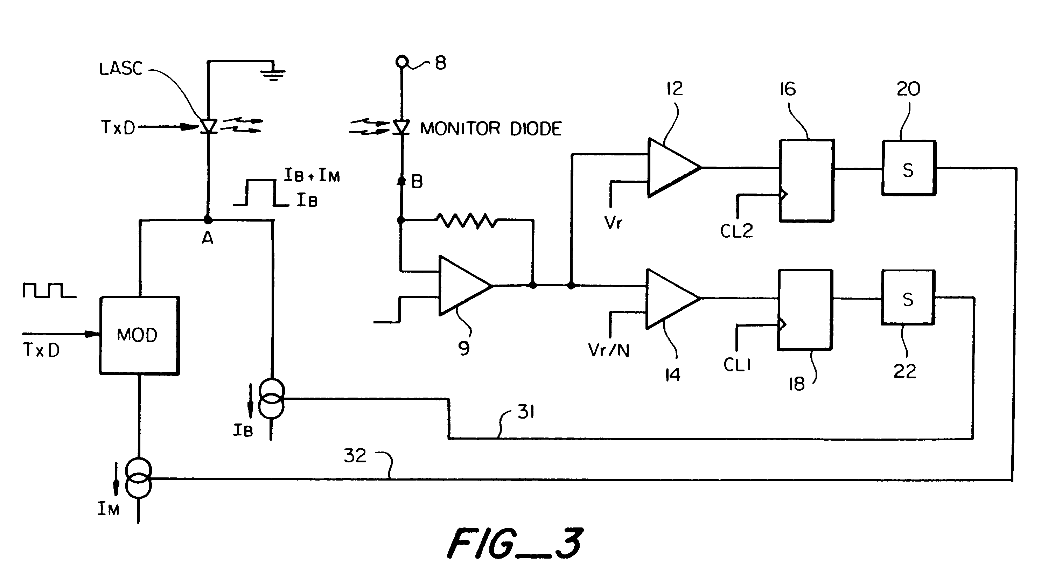

FIG 3 illustrates a schematic illustration of one preferred embodiment of the invention. Referring to this figure, laser diode LASC to be controlled has its anode connected to junction A which in turn is connected in parallel to first and second current sources I_{M} and I_{B}. The laser diode anode is connected to the current source I_{M} through a switch MOD having a data input TxD which completes a path between the anode and the current source I_{M} only during HIGH output frame periods of the laser. Light emitted by the laser diode is monitored, preferably via a back facet of the laser diode, by a monitor diode connected to a bias voltage 8. A current output of an anode B of the monitor diode is convened to a voltage by a transimpedance amplifier 9 which is connected to first and second control circuits 32, 31. Each control circuit includes a comparator 12, 14, a flip-flop 16, 18, having clock inputs CL2 and CL1 respectively, and a current integrator 20, 22. The control loop 31 is connected to the constant current source I_{B}, and the control loop 32 is connected to the other constant current source I_{M}.

In operation, during the LOW training pulse, switch MOD is open so anode A is connected to only the pedestal current source I_{B}. Current from the laser output anode B is converted to a voltage by the amplifier 9 and presented to the comparator 14. Upon being strobed by CL1 by the flip-flop 18, the comparator puts out a HIGH or LOW pulse depending on whether or not the amplifier voltage is above or below the threshold V_{R}/N. This pulse is utilized by the integrator 22 to either decrease or increase a value of IB so as to maintain the LOW power output of the laser constant and toggling about the dynamic reference established by V_{R}/N.

During the HIGH training pulse, switch MOD is closed so that the laser LASC anode A is connected to both the current source IM and IB. An output of the laser LASC is monitored by the monitor diode, and a current from its anode B is again converted to a voltage by the amplifier 9 and presented to the comparators 12, 14. Upon being strobed by CL2, the flip-flop 16 causes the voltage at comparator 12 to be compared to the predetermined HIGH reference voltage V_{R}, and the resultant comparison is inputted to the integrator 20 to adjust I_{M} up or down to keep the HIGH laser output toggling about its reference value.

As can be appreciated, the reference voltages V_{R} and V_{R}/N of the comparators 12, 14 readily result in a laser extinction ratio which is approximately equal to N.

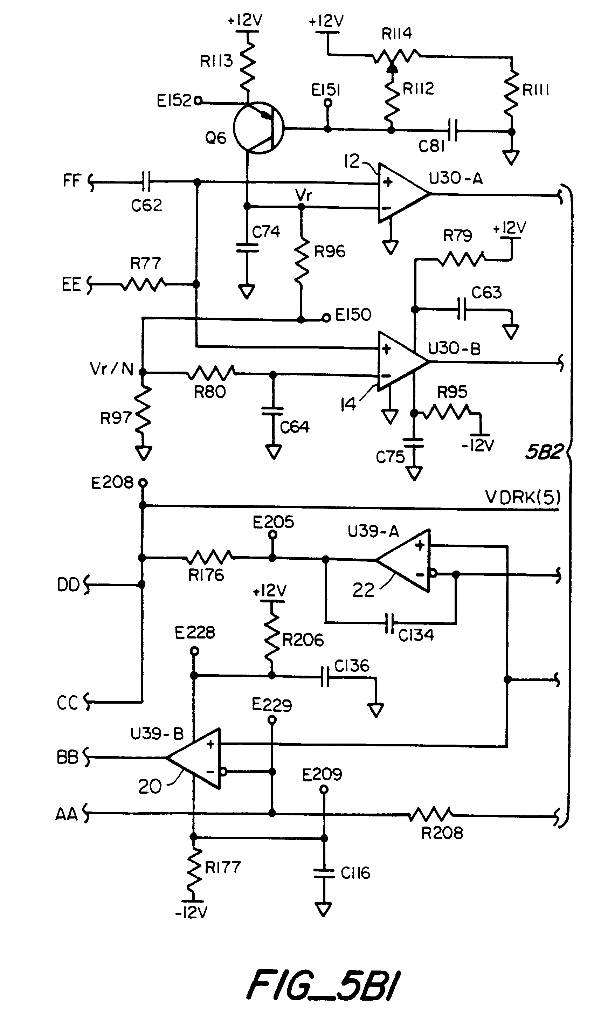

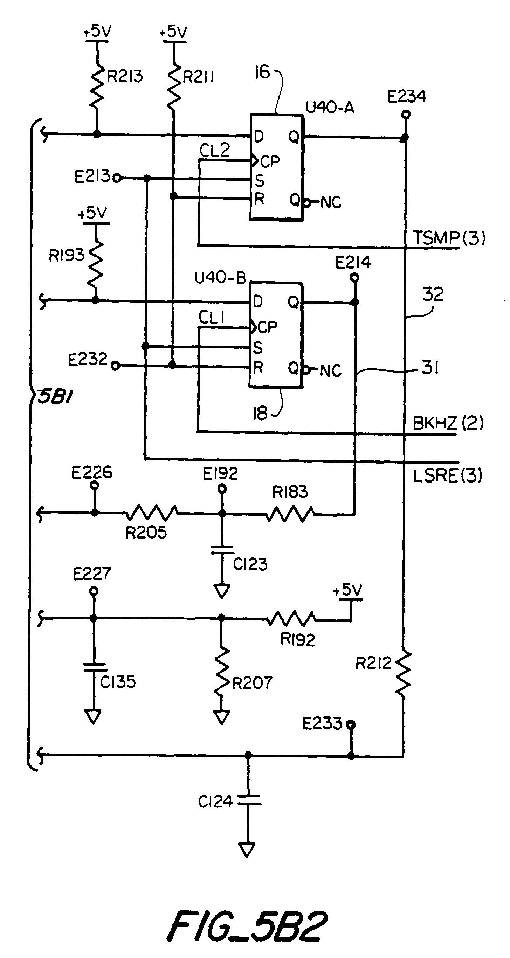

According to another aspect of the invention, the laser control circuit of the present invention is very easy to optimize and set prior to being used for transmitting information. Specifically, according to the invention, the reference voltages Vᵣ and Vᵣ/N are maintained in a fixed ratio by being connected to a voltage divider network, i.e. a pair of resistors in series, as is well understood in the art, and accordingly by simply adjusting an input voltage to the voltage divider network one can easily adjust both the LOW power output and the HIGH power output of the laser simultaneously without varying the laser extinction ratio. Hence, with a single adjustment, the laser output can be optimized so as to achieve the desired extinction ratio N. Prior art lasers typically require multiple adjustments for setting a bias power and a HIGH power. An example of a preferred voltage divider network is illustrated in FIG 5B by resistors R96, R97 which form a voltage divider network for reference voltages inputted to comparators 12, 14.

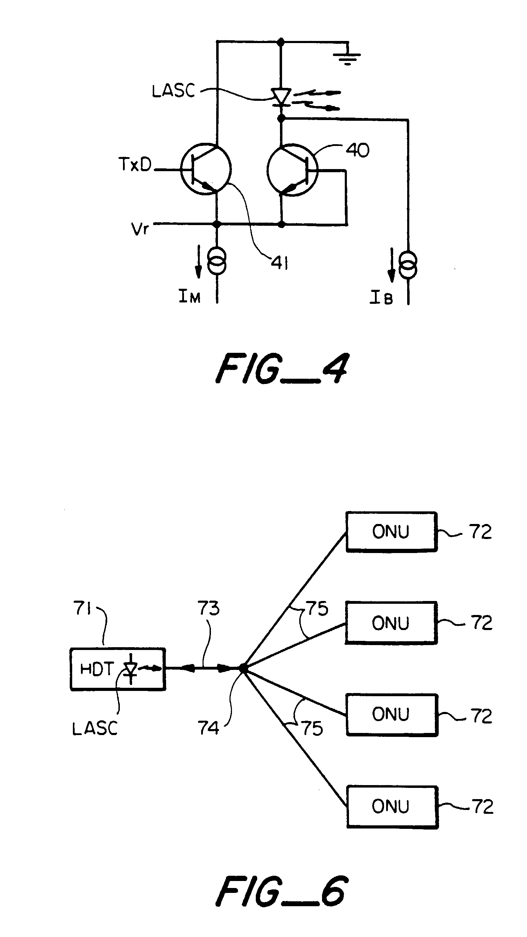

FIG 4 shows one preferred embodiment of the switch MOD, the switch comprising first and second transistors 40, 41, a current source I_{M} being connected to their common anodes, and their cathodes being connected to the laser LASC being modulated, as shown. During periods of HIGH output pulses for the laser LASC, transistor 41 is enabled so that the laser LASC is biased by the threshold current I_{B} and the modulation current I_{M,} and when a LOW pulse is to be generated by the laser LASC the transistor 41 is disabled so that the anode A of the laser is only connected to the pedestal current IB.

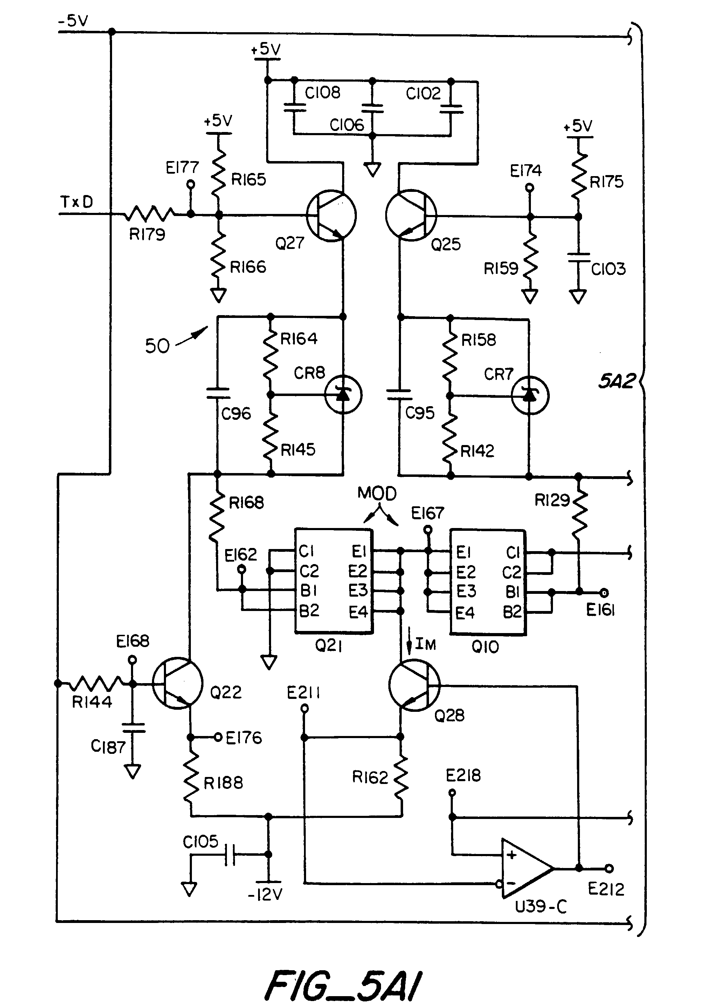

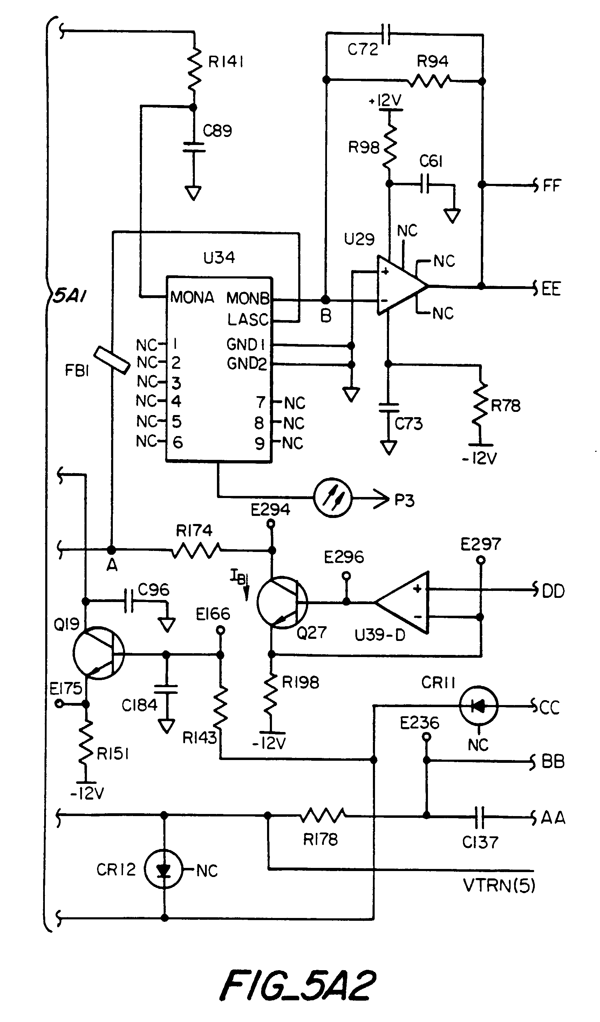

FIGs 5A and 5B illustrate a detailed preferred electrical schematic of a circuit according to the invention. For ease of illustration, elements in FIG 5A and 5B which perform the functions referred to in FIG 3 are identified by identical reference symbols in each of these figures. Referring to FIG 5A, since it is preferred to have a cathode of the laser LASC connected to ground and since TXD data is assumed to be received from an electrical bus at levels of +5V and 0V, a voltage converter 50 is provided for converting the TxD voltages from +5V and 0V to 0V and -5V respectively. These converted voltages are then inputted to the switch MOD which selectively connects the laser anode with the constant current I_{M} as described during HIGH periods. An output B of the monitor laser is connected to the transimpedance amplifier 9 which is then connected to first and second feedback paths 32, 31 each having a comparator, flip-flop, and integrator, as previously described. Feedback loop 31 which includes the comparator 14, flip-flop 18, and integrator 22, controls the pedestal current I_{B}, and the comparator 12, flip-flop 16, and integrator 20 of the feedback loop 32 control the modulation current IM. As is evident by examining FIG 5B, N equals the resistance of R96 divided by the resistance of R97.

FIG 6 illustrates a preferred use for the invention, this figure showing a host digital terminal 71 connected to a plurality of optical network units 72 via at least one optical fiber 73 which preferably transports bidirectional traffic. A splitter/combiner 74 splits a signal originating from the host digital terminal from the fiber 73 to a plurality of additional fibers 75 for transmission to each optical network unit, and conversely signals from each optical network unit 72 are combined at the point 74 so as to be transported to the host digital terminal via the fiber 73. With such an architecture, high receiver sensitivity for each optical network unit is enhanced by maintaining an extinction ratio of a laser transmitting from the host digital terminal at a relatively high level, preferably above 10.

Though the invention has been described by reference to certain preferred embodiments thereof, it should be understood that various modifications can be made thereto without departing from the scope of the invention as defined in the claims, and accordingly the invention is to be limited only by the appended claims.

## Claims

1. Apparatus for controlling a laser light source (LASC), comprising:
means (8,9) for detecting a first voltage magnitude representative of an intensity of optical radiation emitted by the laser light source (LASC) while transmitting at a first output power level (P₁+P₂), the first output power level corresponding to the transmission of a logical 1;
means (12,16,20) for adjusting the first output power level of the laser light source (LASC) to maintain the first voltage magnitude in close proximity to a first preset voltage value (V_{R});
means (8,9,) for detecting a second voltage magnitude representative of an intensity of optical radiation emitted by the laser light source (LASC) while transmitting at a second output power level (P₁), the second output power level corresponding to the transmission of a logical 0;
means (14,18,22) for adjusting the second output power level of the laser light source (LASC) to maintain the second voltage magnitude in close proximity to a second preset voltage value (V_{R}/N); and
means (R96,R97) for simultaneously adjusting the first and second preset voltage values (V_{R}; V_{R}/N) while maintaining constant the ratio of the first preset value (V_{R}) to the second preset value (V_{R}/N).

2. Apparatus according to claim 1, the laser light source (LASC) comprising a digital data modulated laser which emits optical energy in recurrent frames within a time division multiplexed optical communications network (71,72,73).

3. Apparatus according to claims 1 or 2, the first and second detecting means (8,9) comprising a current-to-voltage converter (9) which converts a current representative of the optical radiation output of the laser light source (LASC) into a corresponding voltage.

4. Apparatus according to any of claims 1 to 3, the means for simultaneously adjusting the first and second preset voltage values comprising a resistive voltage divider network (R96,R97).

5. Apparatus according to any of claims 1 to 4, the means (12,16,20) for adjusting the first output power level (P₁+P₂) including a first comparator (12) for comparing the first voltage magnitude to the first preset voltage value (V_{R}) and means (16,20) for responsively adjusting a modulation current (I_{M}) of the laser light source (LASC) to maintain the first voltage magnitude in close proximity to the first preset value (V_{R}).

6. Apparatus according to any of claims 1 to 5, the means (14,18,22) for adjusting the second output power level (P₁) including a second comparator (14) for comparing the second voltage magnitude to the second preset voltage value (V_{R}/N) and means (18,22) for responsively adjusting a bias current (I_{B}) of the laser light source to maintain the second voltage magnitude in close proximity to the second preset value (V_{R}/N).

7. Apparatus according to claim 6 when dependent on claim 5, further comprising first and second flip-flops (16,18) for strobing the first and second comparators (12,14) at times corresponding to transmissions by the laser light source (LASC) of continuous logical 0 and logical 1 signals, respectively.

8. Apparatus according to claim 7, the continuous logical 1 and logical 0 signals each comprising non-data carrying training pulses, each at least 6 bits in length and each embedded within select frames.

9. Apparatus according to claim 8, the continuous logical 1 being transmitted sufficiently long to achieve a stabilized constant value for the detected first voltage magnitude and the continuous logical 0 being transmitted sufficiently long to achieve a stabilized constant value for the detected second voltage magnitude.

10. Apparatus according to any of claims 1 to 9, the first and second detecting means (8, 9) detecting the first and second voltage magnitudes and the first and second adjustment means (12, 16, 20; 14, 18, 22) adjusting the modulation and bias currents (I_{M}; I_{B}), respectively, at a frequency which is sufficiently high so as to maintain a relatively constant extinction ratio (N) of the laser light source (LASC) over time and temperature.

11. Apparatus according to any of claims 1 to 10, the first and second adjusting means (12, 16, 20; 14, 18, 22) increasing the modulation and bias currents (I_{M}; I_{B}), respectively, when the detected first and second voltage magnitudes are below the first and second preset voltage values (V_{R}; V_{R}/N), respectively, and decreasing the modulation and bias currents (I_{M}; I_{B}) when the detected first and second voltage magnitudes are above the first and second preset voltage values (V_{R}; V_{R}/N), respectively.

12. Method of setting the output power of a laser light source (LASC), comprising the steps of:
detecting a first voltage magnitude representative of an intensity of optical radiation emitted by the laser while transmitting at a HIGH output power level (P₁+P₂), the HIGH output power level corresponding to the transmission of a logical 1;
adjusting the HIGH output power level of the laser to maintain the first voltage magnitude in close proximity to a first preset voltage value (V_{R});
detecting a second voltage magnitude representative of an intensity of optical radiation emitted by the laser while transmitting at a LOW output power level (P₁), the LOW output power level corresponding to the transmission of a logical 0;
adjusting the LOW output power level of the laser to maintain the second voltage magnitude in close proximity to a second preset voltage value (V_{R}/N); and
simultaneously adjusting the first and second preset voltage values (V_{R}; V_{R}/N) while maintaining constant the ratio (N) of the first preset value (V_{R}) to the second preset value (V_{R}/N), until a desired laser power output is obtained.

## Patentansprüche

1. Vorrichtung zum Steuern einer Laserlichtquelle (LASC) mit:
einem Mittel (8,9) zum Detektieren einer ersten Spannungsgröße, welche die Intensität einer optischen Strahlung repräsentiert, die von der Laserlichtquelle (LASC) emittiert wird, während diese mit einem ersten Ausgangsleistungspegel (P₁+P₂) sendet, wobei der erste Ausgangsleistungspegel dem Senden einer logischen 1 entspricht;
einem Mittel (12,16,20) zum Einstellen des ersten Ausgangsleistungspegels der Laserlichtquelle (LASC) zum Aufrechterhalten der ersten Spannungsgröße nahe an einem ersten voreingestellten Spannungswert (V_{R});
einem Mittel (8,9,) zum Detektieren einer zweiten Spannungsgröße, welche die Intensität einer optischen Strahlung repräsentiert, die von der Laserlichtquelle (LASC) emittiert wird, während diese mit einem zweiten Ausgangsleistungspegel (P₁) sendet, wobei der zweite Ausgangsleistungspegel dem Senden einer logischen 0 entspricht;
einem Mittel (14,18,22) zum Einstellen des zweiten Ausgangsleistungspegels der Laserlichtquelle (LASC) zum Aufrechterhalten der zweiten Spannungsgröße nahe an einem zweiten voreingestellten Spannungswert (V_{R}/N); und
einem Mittel (R96,R97) zum gleichzeitigen Einstellen des ersten und des zweiten voreingestellten Spannungswerts (V_{R}; V_{R}/N), während das Verhältnis aus dem ersten voreingestellten Wert (V_{R}) und dem zweiten voreingestellten Wert (V_{R}/N) konstant gehalten wird.

2. Vorrichtung nach Anspruch 1, wobei die Laserlichtquelle (LASC) einen digital modulierbaren Laser aufweist, der optische Energie in wiederkehrenden Rahmen innerhalb eines im Zeitmultiplex betriebenen optischen Kommunikationsnetzwerks (71,72,73) emittiert.

3. Vorrichtung nach Anspruch 1 oder 2, wobei das erste und das zweite Detektionsmittel (8,9) einen Strom-zu-Spannungs-Konverter (9) aufweisen, der einen Strom, welcher die von der Laserlichtquelle (LASC) ausgegebene optische Strahlung repräsentiert, in eine entsprechende Spannung konvertiert.

4. Vorrichtung nach einem Ansprüche 1 bis 3, wobei das Mittel zum gleichzeitigen Einstellen des ersten und des zweiten voreingestellten Spannungswerts ein resistives Spannungsteilernetzwerk (R96,R97) aufweist.

5. Vorrichtung nach einem der Ansprüche 1 bis 4, wobei das Mittel (12,16,20) zum Einstellen des ersten Ausgangsleistungspegels (P₁+P₂) einen ersten Komparator (12) zum Vergleichen der ersten Spannungsgröße mit dem ersten voreingestellten Spannungswert (V_{R}), und ein Mittel (16,20) zum darauf antwortenden Einstellen eines Modulationsstroms (I_{M}) der Laserlichtquelle (LASC) aufweist, um die erste Spannungsgröße nahe an dem ersten voreingestellten Wert (V_{R}) aufrechtzuerhalten.

6. Vorrichtung nach einem der Ansprüche 1 bis 5, wobei das Mittel (14,18,22) zum Einstellen des zweiten Ausgangsleistungspegels (P₁) einen zweiten Komparator (14) zum Vergleichen der zweiten Spannungsgröße mit dem zweiten voreingestellten Spannungswert (V_{R}/N), und ein Mittel (18,22) zum darauf antwortenden Einstellen eines Bias-Stroms (I_{B}) der Laserlichtquelle aufweist, um die zweite Spannungsgröße nahe an dem zweiten voreingestellten Wert (V_{R}/N) aufrechtzuerhalten.

7. Vorrichtung nach Anspruch 6, wenn dieser auf Anspruch 5 zurückbezogen ist, ferner mit einem ersten und einem zweiten Flip-Flop (16,18) zum Stroben des ersten und des zweiten Komparators (12,14) zu solchen Zeitpunkten, die dem Senden von kontinuierlichen logischen 0- bzw. logischen 1-Signalen von der Laserlichtquelle (LASC) entsprechen.

8. Vorrichtung nach Anspruch 7, wobei jedes von den kontinuierlichen logischen 1- und logischen 0-Signalen nicht-Daten-tragende Trainingsimpulse aufweist, von denen jedes wenigstens eine Länge von 6 Bit aufweist und in Auswahlrahmen eingebettet ist.

9. Vorrichtung nach Anspruch 8, wobei die kontinuierliche logische 1 zum Erreichen eines stabilisierten, konstanten Werts für die detektierte erste Spannungsgröße ausreichend lange gesendet wird, und die kontinuierliche logische 0 zum Erreichen eines stabilisierten, konstanten Werts für die detektierte zweite Spannungsgröße ausreichend lange gesendet wird.

10. Vorrichtung nach einem der Ansprüche 1 bis 9, wobei das erste und das zweite Detektionsmittel (8, 9) die erste und die zweite Spannungsgröße detektieren, und das erste und das zweite Einstellungsmittel (12, 16, 20; 14, 18, 22) den Modulations-bzw. den Bias-Strom (I_{M}, I_{B}) bei einer derart ausreichend hohen Frequenz einstellen, daß ein relativ konstantes Extinktionsverhältnis (N) der Laserlichtquelle (LASC) über Zeit und Temperatur aufrechterhalten wird.

11. Vorrichtung nach einem der Ansprüche 1 bis 10, wobei das erste und das zweite Einstellungsmittel (12, 16, 20; 14, 18, 22) den Modulations- bzw. den Bias-Strom (I_{M}; I_{B}) erhöhen, wenn die erste und die zweite detektierte Spannungsgröße unterhalb dem ersten bzw. dem zweiten voreingestellten Spannungswert (V_{R}; V_{R}/N) sind, und den Modulations- und den Bias-Strom (I_{M}; I_{B}) verringern, wenn die erste und die zweite detektierte Spannungsgröße oberhalb des ersten bzw. des zweiten voreingestellten Spannungswerts (V_{R}; V_{R}/N) sind.

12. Verfahren zum Einstellen der Ausgangsleistung einer Laserlichtquelle (LASC) mit den Schritten:
Detektieren einer ersten Spannungsgröße, welche repräsentativ für die Intensität einer optischen Strahlung ist, die von dem Laser emittiert wird, während dieser mit einem H-Ausgangsleistungspegel (P₁+P₂) sendet, wobei der H-Ausgangsleistungspegel dem Senden einer logischen 1 entspricht;
Einstellen des H-Ausgangsleistungspegels des Lasers, um die erste Spannungsgröße nahe an einem ersten voreingestellten Spannungswert (V_{R}) aufrechtzuerhalten;
Detektieren einer zweiten Spannungsgröße, welche repräsentativ für die Intensität einer optischen Strahlung ist, die von dem Laser emittiert wird, während dieser mit einem L-Ausgangsleistungspegel (P₁) sendet, wobei der L-Ausgangsleistungspegel dem Senden einer logischen 0 entspricht;
Einstellen des L-Ausgangsleistungspegels des Lasers, um die zweite Spannungsgröße nahe an einem zweiten voreingestellten Spannungswert (V_{R}/N) aufrechtzuerhalten; und
gleichzeitiges Einstellen des ersten und des zweiten voreingestellten Spannungswerts (V_{R}; V_{R}/N), während das Verhältnis (N) aus dem ersten voreingestellten Wert (V_{R}) und dem zweiten voreingestellten Wert (V_{R}/N) konstant aufrechterhalten wird, bis eine gewünschte Laserausgangsleistung erzielt wird.

## Revendications

1. Appareil de commande d'une source de lumière laser (LASC), comprenant :
- des moyens (8,9) pour détecter une première amplitude de tension représentative d'une intensité de rayonnement optique émis par la source de lumière laser (LASC) lorsqu'elle transmet à un premier niveau de puissance de sortie (P₁+P₂), le premier niveau de puissance de sortie correspondant à la transmission d'un niveau logique 1 ;
- des moyens (12,16,20) pour l'ajustement du premier niveau de puissance de sortie de la source de lumière laser (LASC) pour maintenir la première amplitude de tension à un niveau très proche d'une première valeur de tension présélectionnée (V_{R}) ;
- des moyens (8,9) pour détecter une deuxième amplitude de tension représentative d'une intensité du rayonnement optique émis par la source de lumière laser (LASC) lorsqu'elle transmet à un deuxième niveau de puissance de sortie (P₁), le deuxième niveau de puissance de sortie correspondant à la transmission d'un niveau logique 0 ;
- des moyens (14,18,22) pour l'ajustement du deuxième niveau de puissance de sortie de la source de lumière laser (LASC) pour maintenir la deuxième amplitude de tension à un niveau très proche d'une deuxième valeur de tension présélectionnée (V_{R}/N) ; et
- des moyens (R96,R97) pour l'ajustement simultané des première et deuxième valeurs de tension présélectionnées (V_{R}; V_{R}/N) tout en maintenant constant le rapport entre la première valeur présélectionnée (V_{R}) et la deuxième valeur présélectionnée (V_{R}/N).

2. Appareil selon la revendication 1, la source de lumière laser (LASC) comprenant un laser modulé à données numériques qui émet une énergie optique sous forme de trames récurantes à l'intérieur d'un réseau de communication optique multiplexé à division de temps (71,72,73).

3. Appareil selon l'une des revendications 1 et 2, les premiers et deuxième moyens de détection (8,9) comprenant un convertisseur courant-tension (9) qui convertit un courant représentatif de la sortie de rayonnement optique délivrée par la source de lumière laser (LASC) en une tension correspondante.

4. Appareil selon l'une quelconque des revendications 1 à 3, les moyens d'ajustement simultané des première et deuxième tensions présélectionnées comportant un réseau diviseur de tension résistif (R96,R97).

5. Appareil selon l'une quelconque des revendications 1 à 4, les moyens (12,16,20) d'ajustement du premier niveau de puissance de sortie (P₁+P₂) comportant un premier comparateur (12) pour comparer la première amplitude de tension à la première amplitude présélectionnée (V_{R}) et des moyens (16,20) pour, en réponse, ajuster un courant de modulation (I_{M}) de la source de lumière laser (LASC) pour maintenir la première amplitude de tension à une valeur très proche de la première valeur présélectionnée (V_{R}).

6. Appareil selon l'une quelconque des revendications 1 à 5, les moyens (14,18,22) d'ajustement du deuxième niveau de puissance de sortie (P1) comportant un deuxième comparateur (14) pour comparer la deuxième amplitude de tension à la deuxième valeur de tension présélectionnée (V_{R}/N) et des moyens (18,22) pour, en réponse, ajuster un courant de polarisation (I_{B}) de la source de lumière laser pour maintenir la deuxième amplitude de tension à une valeur très proche de la deuxième valeur présélectionnée (V_{R}/N).

7. Appareil selon la revendication 6, dépendante de la revendication 5, comprenant en outre des première et deuxième bascule flip-flop (16,18) pour commander les premier et deuxième comparateurs (12,14) à des instants correspondant aux transmissions, par la source de lumière laser (LASC), de signaux logiques continus 0 et 1 respectivement.

8. Appareil selon la revendication 7, les signaux continus logiques 1 et 0 comprenant chacun des impulsions sous forme de trains de transport de données, ayant chacune au moins six bits de longueur et se présentant sous la forme de trames sélectionnées.

9. Appareil selon la revendication 8, le niveau logique 1 continu étant transmis pendant une durée suffisamment longue pour obtenir une valeur constante stabilisée pour la première amplitude de tension détectée et le niveau logique 0 étant transmis pendant une durée suffisamment longue pour obtenir une valeur constante stabilisée pour une deuxième amplitude de tension détectée.

10. Appareil selon l'une quelconque des revendications 1 à 9, les premier et deuxième moyens de détection (8,9) détectant les première et deuxième amplitudes de tension et les premier et deuxième moyens d'ajustement (12,16,20;14,18,22) ajustant les courants de modulation et de polarisation (I_{M};I_{B}) respectivement, à une fréquence suffisamment élevée pour maintenir un rapport d'extinction relativement constant (N) de la source de lumière laser (LASC) en fonction du temps et de la température.

11. Appareil selon l'une quelconque des revendications 1 à 10, les premier et deuxième moyens d'ajustement (12,16,20;14,18,22) augmentant les courants de modulation et de polarisation (I_{N};I_{B}), respectivement, lorsque les première et deuxième amplitudes de tension détectées se situent en dessous des première et deuxième valeurs de tension présélectionnées (V_{R};V_{R}/N) respectivement, et diminuant les courant de modulation et de polarisation (I_{M};I_{B}) lorsque les première et deuxième amplitudes de tension se situent au-dessus des première et deuxième valeurs de tension présélectionnées (V_{R};V_{R}/N), respectivement.

12. Procédé de réglage de la puissance de sortie d'une source de lumière laser (LASC), comprenant les étapes consistant à :
détecter une première amplitude de tension représentative d'une intensité de rayonnement optique émis par le laser lors de l'émission d'un niveau de puissance de sortie élevé (P₁+P₂), le niveau de puissance de sortie élevé correspondant à l'émission d'un niveau logique 1 ;
ajuster le niveau de puissance de sortie élevé du laser pour maintenir la première amplitude de tension à une valeur très proche d'une première valeur de tension présélectionnée (V_{R}) ;
détecter une deuxième amplitude de tension représentative d'une intensité de rayonnement optique émis par le laser lors de la transmission d'un niveau de puissance de sortie bas (P₁), le niveau de puissance de sortie bas correspondant à la transmission d'un niveau logique 0 ;
ajuster le niveau de puissance de sortie bas du laser pour maintenir la deuxième amplitude de tension à une valeur très proche d'une deuxième valeur de tension présélectionnée (V_{R}/N) ; et
ajuster simultanément les première et deuxième valeurs de tension présélectionnées (V_{R};V_{R}/N) tout en maintenant constant le rapport (N) de la première valeur présélectionnée (V_{R}) et de la deuxième valeur présélectionnée (V_{R}/N), jusqu'à l'obtention d'une sortie de puissance laser désirée.
